# DEMANDE DE BREVET EUROPEEN

(11) **EP 3 667 667 A1**
(43) Date de publication de la demande: **17.06.2020**
(21) Numéro de dépôt: 19214953.2
(22) Date de dépôt: 10.12.2019
(51) Int. Cl.: G11C 8/08, G11C 5/02, G11C 5/06, G11C 7/18, G11C 8/10, G11C 8/12, G11C 8/14, G11C 11/413, G11C 11/417

(54) **MEMOIRE RAM REALISEE SOUS LA FORME D'UN CIRCUIT INTEGRE 3D**

(30) Priorité: 11.12.2018 FR 1872707
(71) Demandeur: Commissariat à l'énergie atomique et aux énergies alternatives, 75015 Paris (FR)
(72) Inventeur: MAKOSIEJ, Adam, 38054 GRENOBLE CEDEX 09 (FR); GIRAUD, Bastien, 38054 GRENOBLE CEDEX 09 (FR); NOEL, Jean-Philippe, 38054 GRENOBLE CEDEX 09 (FR)
(74) Mandataire: Brevalex

(57) **Abrégé**

Mémoire 3D-RAM (100) comprenant :
- plusieurs matrices (103) de cellules mémoires (102) réparties dans plusieurs couches mémoires (104) superposées ;
- un circuit d'attaque de lignes de mots ;
- un décodeur d'adresses couplé au circuit d'attaque des lignes de mots ;
dans laquelle le décodeur d'adresses et le circuit d'attaque de lignes de mots sont disposés dans une couche d'électronique de commande (112) distincte des couches mémoires,
et dans laquelle, dans chacune des couches mémoires, chacune des lignes de mots est reliée à une sortie d'un dispositif électronique de sélection (108) disposé dans la couche mémoire, dont une entrée de donnée est reliée au circuit d'attaque de lignes de mots, dont une entrée de commande est reliée au décodeur d'adresses, et qui est configuré pour laisser passer ou non un signal d'accès aux transistors en fonction de la valeur d'un signal de commande reçu.

## Description

### DOMAINE TECHNIQUE

Le domaine technique de l'invention est celui des mémoires RAM (mémoire vive) réalisées sous la forme de circuits intégrés 3D (3 dimensions), c'est-à-dire de circuits comprenant plusieurs couches superposées, ou réalisés dans plusieurs niveaux électroniques superposés, et appelées 3D-RAM. L'invention s'applique notamment à la réalisation de mémoires SRAM (mémoire vive statique) ou DRAM (mémoire vive dynamique), et notamment 3D-SRAM ou 3D-DRAM.

### ÉTAT DE LA TECHNIQUE ANTÉRIEURE

Un circuit intégré plan, ou 2D, est réalisé sur un seul substrat, les composants électroniques de ce circuit étant réalisés les uns à côté des autres sur ce substrat.

Un circuit intégré 3D correspond à un circuit électronique dont les composants électroniques sont répartis dans plusieurs couches, ou niveaux ou substrats, distinctes, superposées les unes au-dessus des autres et reliées électriquement entre elles.

Une mémoire 3D-RAM comporte généralement plusieurs couches, ou niveaux, superposées de cellules mémoires RAM. Chaque cellule mémoire correspond à un élément mémoire dans lequel 1 bit est mémorisé. Les cellules mémoires sont agencées sous la forme de matrices, c'est-à-dire de lignes et de colonnes de cellules mémoires. Les cellules mémoires agencées sur une même ligne partagent une même ligne de mots commandant l'accès à ces cellules mémoires. Les cellules mémoires agencées sur une même colonne partagent une même ligne de bit, et éventuellement une même ligne de bits complémentaire.

Le plus souvent, chacune des couches mémoires a le même design, ou la même architecture, qu'une mémoire standard 2D ou plane, comme cela est par exemple décrit dans le document US 2015/019802 A1. Dans ce document, plusieurs matrices de cellules mémoires sont réalisées dans plusieurs niveaux superposés. L'architecture de la mémoire proposée ne permet pas de profiter de la superposition des couches utilisées.

Le document « A High-speed, Low-power 3D-SRAM Architecture » de H. Nho et al., 2008 IEEE Custom Integrated Circuits Conference, décrit une mémoire 3D-SRAM dans laquelle les lignes de bits, ou « bit lines » en anglais, traversent les différentes couches de cellules mémoires, chacune étant reliées à des cellules mémoires qui sont superposées les unes au-dessus des autres. Des lignes de bits globales, ou « global bitlines », sont réalisées dans un niveau, ou couche, inférieur, chacune de lignes de bits globales reliant plusieurs lignes de bits à des amplificateurs de détection de la mémoire. Cette architecture ne permet toutefois pas d'obtenir un gain de surface intéressant puisque la nécessité de faire passer les lignes de bits dans les cellules mémoires entraîne une perte de surface d'environ 18% par cellule mémoire par rapport à une cellule mémoire SRAM standard.

Le document « 3D-Integrated SRAM Components for High-Performance Microprocessors » de K. Puttaswamy et al., IEEE Transactions on Computers, Vol. 58, N° 10, Octobre 2009, décrit d'autres architectures de mémoires 3D-SRAM permettant de réduire la longueur des interconnexions dans la mémoire. Dans les différentes architectures proposées, le fonctionnement de la mémoire implique que toutes les matrices de cellules mémoires superposées fonctionnent simultanément, la sélection des données souhaitées étant réalisée après la lecture de l'ensemble des matrices de cellules mémoires. Un tel fonctionnement n'est donc pas optimal en termes de consommation électrique de la mémoire.

### EXPOSÉ DE L'INVENTION

Un but de la présente invention est de proposer une mémoire RAM réalisée sous la forme d'un circuit intégré 3D dont l'architecture permet la réalisation de connexions entre les différentes couches, ou niveaux, de cellules mémoires avec de faibles longueurs, permettant de réduire l'empreinte, ou la surface occupée, et ainsi maximiser la densité de cellules mémoires pour une surface donnée, et également d'améliorer les performances de la mémoire notamment en termes de consommation électrique de la mémoire.

Pour cela, il est proposé une mémoire 3D-RAM comprenant au moins :
- plusieurs matrices de cellules mémoires réparties dans plusieurs couches mémoires superposées et telles que dans chaque matrice de cellules mémoires, les cellules mémoires disposées sur une même ligne de la matrice sont reliées à une ligne de mots associée à ladite ligne de la matrice ;
- un circuit d'attaque de lignes de mots ;
- un décodeur d'adresses couplé au circuit d'attaque des lignes de mots ;
dans laquelle le décodeur d'adresses et le circuit d'attaque de lignes de mots sont disposés dans une couche d'électronique de commande distincte des couches mémoires,
et dans laquelle, dans chacune des couches mémoires, chacune des lignes de mots est reliée à une sortie d'un dispositif électronique de sélection disposé dans la couche mémoire comprenant lesdites lignes de mots, dont une entrée de donnée est reliée au circuit d'attaque de lignes de mots, dont une entrée de commande est reliée au décodeur d'adresses, et qui est configuré pour laisser passer ou non un signal reçu sur son entrée de données en fonction de la valeur d'un signal reçu sur son entrée de commande.

Selon l'invention, il est proposé une mémoire 3D-RAM comprenant au moins :
- plusieurs matrices de cellules mémoires réparties dans plusieurs couches mémoires superposées et telles que dans chaque matrice de cellules mémoires, les cellules mémoires disposées sur une même ligne de la matrice sont reliées à une ligne de mots associée à ladite ligne de la matrice ;
- un circuit d'attaque de lignes de mots ;
- un décodeur d'adresses couplé au circuit d'attaque des lignes de mots ; dans laquelle :
- le décodeur d'adresses et le circuit d'attaque de lignes de mots sont disposés dans une couche d'électronique de commande distincte des couches mémoires,
- dans chacune des couches mémoires, chacune des lignes de mots est reliée à une sortie d'un dispositif électronique de sélection disposé dans la couche mémoire comprenant lesdites lignes de mots, dont une entrée de donnée est reliée au circuit d'attaque de lignes de mots, dont une entrée de commande est reliée au décodeur d'adresses, et formant un interrupteur commandé interposé entre ladite ligne de mots et le circuit d'attaque de lignes de mots et configuré pour laisser passer ou non un signal reçu sur son entrée de données en fonction de la valeur d'un signal de sélection d'une des couches mémoires reçu sur son entrée de commande et délivré par le décodeur d'adresses,
- tous les dispositifs électroniques de sélection disposés dans une même couche mémoire sont configurés pour recevoir sur leur entrée de commande un même signal de sélection d'une des couches mémoires, et
- chaque dispositif électronique de sélection comporte en outre un élément de polarisation de la ligne de mots reliée au dispositif électronique de sélection configuré pour assurer une polarisation de ladite ligne de mots à un potentiel électrique de référence lorsque le dispositif électronique de sélection ne laisse pas passer le signal reçu sur son entrée de données .

Dans cette mémoire 3D-RAM, chaque couche mémoire ne comporte pas un circuit d'attaque de lignes de mots (« word line driver» en anglais) et un décodeur d'adresses (« row decoder » en anglais). Le circuit d'attaque de lignes de mots et le décodeur d'adresses sont disposés dans une couche d'électronique de commande distincte des couches dans lesquelles sont formées les matrices de cellules mémoires. Ainsi, l'espace occupé par le circuit d'attaque de lignes de mots et par le décodeur d'adresses est libéré des couches mémoires, ce qui permet de réduire la surface occupée par les couches mémoires, et donc la surface occupée globalement par la mémoire 3D.

Ce déplacement du circuit d'attaque de lignes de mots et du décodeur d'adresses dans une couche différente des couches mémoires est possible grâce à l'utilisation des dispositifs électroniques de sélection qui permettent de sélectionner les cellules mémoires d'une des matrices de cellules mémoires dans lesquelles une opération de lecture ou d'écriture est réalisée.

Cette architecture de mémoire minimise donc, au sein de chacune des couches mémoires, les composants électroniques autres que ceux formant les cellules mémoires, du fait que dans une couche mémoire, les dispositifs électroniques de sélection occupent moins d'espace que le circuit d'attaque de lignes de mots et le décodeur d'adresses. Pour une surface donnée, la capacité de mémorisation pouvant être obtenue est donc plus important que celle pouvant être obtenues avec les architectures de mémoires de l'art antérieur.

Cette architecture de mémoire est adaptative et flexible, et peut être facilement adaptée à différentes applications en ajoutant différents fonctionnalités via l'ajout de blocs fonctionnels supplémentaires au sein des différentes couches de la mémoire.

Un autre avantage apporté par cette architecture de mémoire est que le réseau, ou maillage, d'alimentation (« power mesh » en anglais) de la mémoire est semblable à celui d'une mémoire classique. Cette architecture peut donc être adaptée à des mémoires existantes sans modification de leur réseau d'alimentation, ne créant donc pas de dissymétrie ni d'erreur lors de cette adaptation.

Les dispositifs électroniques de sélection se comportent comme un multiplexeur commandé depuis le décodeur d'adresse, du fait qu'une donnée envoyée depuis le circuit d'attaque de lignes de mots est transmise sur les lignes de mots de la matrice de cellules mémoires souhaitée grâce à la sélection réalisée par les dispositifs électronique de sélection (seuls les dispositifs électroniques de sélection reliés à la matrice souhaitée laissent passer le signal reçu sur leur entrée de données). Les dispositifs électroniques de sélection ne réalisent pas une amplification des signaux reçus sur leur entrée, et n'apportent pas de puissance supplémentaire aux signaux reçus.

Chaque dispositif électronique de sélection peut former un interrupteur commandé entre une des lignes de mots et le circuit d'attaque de lignes de mots. Les dispositifs électroniques de sélection peuvent être commandés par un signal de sélection de niveau ou de couche mémoire. Un même signal de sélection de niveau ou de couche mémoire peut être transmis aux dispositifs électroniques de sélection se trouvant sur un même niveau ou une même couche mémoire. Chaque signal de sélection de niveau ou de couche mémoire peut être transmis sur une ligne électriquement conductrice couplant le décodeur d'adresses aux entrées de commande des dispositifs électroniques de sélection d'une même couche mémoire ou d'un même niveau.

En outre, cette architecture de mémoire 3D a également pour avantage d'être réalisée avec de courtes connexions électriques et une forte densité d'interconnexions entre les couches, favorisant l'obtention de bonnes performances.

De plus, du fait qu'une opération de lecture ou d'écriture dans une matrice de cellules mémoires n'est réalisée que dans la matrice souhaitée, la consommation électrique de la mémoire est réduite par rapport aux mémoires de l'art antérieur dans lesquelles toutes les matrices de cellules mémoires sont sollicitées pour réaliser une opération de lecture ou d'écriture destinée à une seule matrice de cellules mémoires.

Cette architecture de mémoire s'applique avantageusement pour des applications faisant appel à des mémoires intégrées.

La surface occupée par la mémoire correspond à la surface occupée par la projection, dans un plan parallèle aux couches mémoires et à la couche d'électronique de commande, de l'empilement formé par les couches mémoires et la couche d'électronique de commande.

Les dispositifs électroniques de sélection ont un comportement proche de celui d'un multiplexeur car grâce à ces dispositifs, des données transmises depuis le circuit d'attaque de lignes de mots à destination de l'ensemble des matrices de cellules mémoires ne sont transférées qu'aux lignes de mots d'une matrice de cellules mémoires sélectionnée grâce aux dispositifs électroniques de sélection.

De manière avantageuse, la mémoire peut être de type 3D-SRAM, c'est-à-dire que les cellules mémoires sont de type SRAM. Avec de telles cellules mémoires de type SRAM, le partage des entrées / sorties et de la logique de commande entre les couches mémoires superposées n'impacte pas les dimensions des matrices empilées en raison de l'absence du besoin de rafraîchissement séquentiel de chacune des cellules mémoires.

En variante, la mémoire peut être de type 3D-DRAM, c'est-à-dire que les cellules mémoires sont de type DRAM.

Dans tout le document, l'expression « couche mémoire » désigne un ensemble de couches physique de matériaux semi-conducteurs, diélectriques et conducteurs, formant une seule « plaque » (ou « tier » en anglais), comportant une partie dite « Back-End » constituée classiquement de plusieurs niveaux de connexions métalliques séparées par des couches diélectriques et reliées éventuellement par des vias métalliques traversant ces couches diélectriques, et une partie dite « Front-End » comprenant entre autre une couche semi-conductrice. Les dispositifs électroniques de sélection formant des éléments de commande des cellules mémoires sont par exemple réalisés au moyen de transistors réalisés en surface de la couche semi-conductrice. Les cellules mémoire, selon leur nature seront réalisées dans l'une et/ou l'autre des parties « Front-End » ou « Back-End ». Ainsi, des cellules mémoire de type SRAM seront réalisées à partir de transistors formés en surface de la couche semi-conductrice et reliés entre eux par des connexions métalliques placés dans le « back-end ». Des cellules mémoire de type mémoires résistives peuvent être réalisées au moyen de matériaux spécifiques positionnées dans la partie « Back-End », par exemple à l'intérieur d'une couche diélectrique.

De plus, les couches mémoires peuvent être superposées les unes au-dessus des autres et peuvent être disposées au-dessus de la couche d'électronique de commande. En variante, les couches mémoires peuvent être disposées en dessous de la couche d'électronique de commande.

En variante, il est possible que la couche d'électronique de commande soit disposée entre deux couches mémoires. Cette configuration a pour avantage que la longueur des interconnexions entre la couche d'électronique et de commande et les couches mémoires les plus éloignées soit inférieure à celle obtenue lorsque la couche d'électronique de commande est disposée sous ou sur les couches mémoires.

Chaque dispositif électronique de sélection peut comporter une porte de transfert (« transfert gate », ou « pass gate », en anglais) formant l'interrupteur commandé, dont une entrée forme l'entrée du dispositif électronique de sélection, dont une sortie forme la sortie du dispositif électronique de sélection, et dont une entrée de commande forme l'entrée de commande du dispositif électronique de sélection. L'utilisation d'une telle porte de transfert est avantageuse car elle permet un bon maintien des niveaux 0 et 1 des signaux envoyés sur les lignes de mots. De plus, une telle porte de transfert n'a besoin que d'un seul signal de commande pour fonctionner.

En variante, chaque dispositif électronique de sélection peut comporter un premier transistor à effet de champ, ou FET, formant l'interrupteur commandé et configuré tel que :
- une première électrode, correspondant à la source ou au drain du premier transistor, forme l'entrée du dispositif électronique de sélection,
- une deuxième électrode, différente de la première électrode et correspondant au drain ou à la source du premier transistor, forme la sortie du dispositif électronique de sélection,
- une grille forme l'entrée de commande du dispositif électronique de sélection.

De plus, chaque dispositif électronique de sélection, et plus particulièrement chaque élément de polarisation, peut comporter un deuxième transistor à effet de champ configuré tel que :
- une première électrode, correspondant à la source ou au drain du deuxième transistor, est reliée à la sortie du dispositif électronique de sélection,
- une deuxième électrode, différente de la première électrode et correspondant au drain ou à la source du deuxième transistor, est reliée au potentiel électrique de référence,
- une grille est reliée à un circuit de contrôle disposé dans la couche d'électronique de commande.

Ce deuxième transistor peut être avantageusement mis à l'état passant par le circuit de contrôle lorsqu'aucune opération de lecture ou d'écriture n'est mise en œuvre dans les cellules mémoires associées à la ligne de mots à laquelle le dispositif électronique de sélection, dont fait partie ce deuxième transistor, est relié.

La mémoire peut comporter en outre des lignes de mots globales, chaque ligne de mots globale étant reliée à au moins une entrée d'un dispositif électronique de sélection présent dans chacune des couches mémoires.

La mémoire peut être telle que :
- dans chaque matrice de cellules mémoires, les cellules mémoires disposées sur une même colonne de la matrice peuvent être reliées à une ligne de bits et une ligne de bits complémentaire associées à ladite colonne de la matrice ;
- les lignes de bits peuvent être reliées à des lignes de bits globales telles que chaque ligne de bits globale soit reliée à au moins une ligne de bits de chacune des couches mémoires, et les lignes de bits complémentaires peuvent être reliées à des lignes de bits complémentaires globales telles que chaque ligne de bits complémentaire globale soit reliée à au moins une ligne de bits complémentaire de chacune des couches mémoires ;
- les lignes de bits globales et les lignes de bits complémentaires globales peuvent être reliées à des amplificateurs de détection configurés pour réaliser une lecture des cellules mémoires.

Selon un mode de réalisation particulier, chaque couche mémoire peut comporter plusieurs matrices de cellules mémoires. Cette configuration est avantageuse car elle permet d'avoir, à capacité de mémorisation égale, un plus faible encombrement. Cette configuration permet également de réaliser une mémoire à accès multiples. En outre, en réduisant le nombre de lignes et de colonnes de cellules mémoires pour chaque matrice de cellules mémoires, cela réduit les capacités formées par les vias auxquels ces cellules mémoires sont reliées.

Dans chacune des couches mémoires, lorsque chaque couche mémoire comporte plusieurs matrices de cellules mémoires, chacune des lignes de bits et chacune des lignes de bits complémentaires peut être reliée à une entrée de donnée d'un deuxième dispositif électronique de sélection disposé dans la couche mémoire comprenant lesdites lignes de bits et lignes de bits complémentaires, dont une entrée de commande est reliée à un circuit de commande de lecture disposé dans la couche d'électronique de commande, dont une sortie est reliée à l'un des amplificateurs de détection, et qui est configuré pour laisser passer ou non un signal reçu sur son entrée de données en fonction de la valeur d'un signal reçu sur son entrée de commande.

Lorsque chaque couche mémoire ne comporte pas plusieurs matrices de cellules mémoires, dans chacune des couches mémoires, chacune des lignes de bits et chacune des lignes de bits complémentaires peut être reliée à une entrée d'un deuxième dispositif électronique de sélection disposé dans la couche mémoire comprenant lesdites lignes de bits et lignes de bits complémentaires, dont une entrée de commande peut être reliée à un circuit de commande de lecture disposé dans la couche d'électronique de commande, dont une sortie peut être reliée à l'un des amplificateurs de détection, et qui peut être configuré pour laisser passer ou non un signal reçu sur son entrée de données en fonction de la valeur d'un signal reçu sur son entrée de commande.

Les deuxièmes dispositifs électroniques de sélection permettent, lors d'une lecture de cellules mémoires, de ne relier aux amplificateurs de détection que les lignes de bits et les lignes de bits complémentaires des cellules, évitant ainsi de relier également les amplificateurs de détection aux autres lignes de bits et aux autres lignes de bits complémentaires. Cela réduit les capacités présentes en entrée des amplificateurs de détection.

Dans un mode de réalisation particulier, la mémoire peut comporter entre outre :
- dans chacune des couches mémoires, au moins un circuit de détection de variations PVT (« Process, Voltage, Temperature », ou variations de procédé, de tension et de température) et un circuit d'application de tensions de polarisation de caissons de transistors des cellules mémoires,
- dans la couche d'électronique de commande, un circuit de génération de tensions de polarisation de caissons couplé aux circuits de détection de variation PVT et aux circuits d'application de tensions de polarisation de caissons de transistors des cellules mémoires.

L'architecture de la mémoire est bien adaptée pour recevoir de tels circuits permettant d'adapter les valeurs des tensions de polarisation appliquées sur les caissons des transistors des cellules mémoires en fonction des variations PVT détectées dans les couches mémoires.

De manière générale, la couche d'électronique de commande est bien adaptée pour recevoir les circuits liés aux entrées et sorties de la mémoire, ces circuits étant généralement encombrants.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une mémoire 3D-RAM selon un premier mode de réalisation ;
- les figures 2 et 3 représentent des variantes de réalisation d'un dispositif électronique de sélection utilisé dans la mémoire 3D-RAM selon l'invention ;
- la figure 4 représente une mémoire 3D-RAM selon une variante du premier mode de réalisation ;
- la figure 5 représente partiellement une mémoire 3D-RAM selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

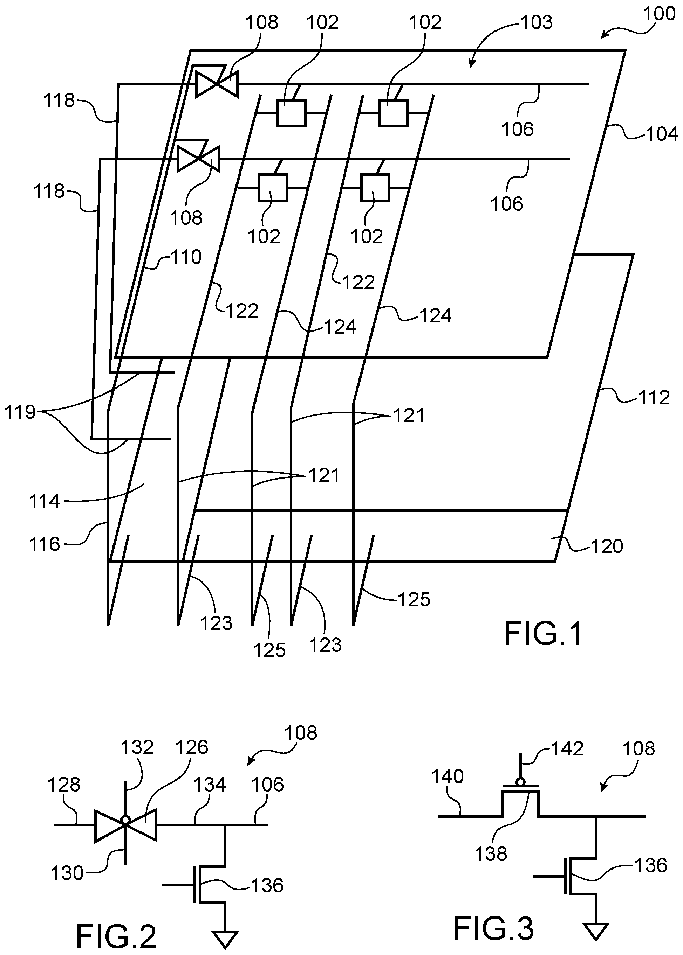

Une mémoire 100 de type 3D-RAM, selon un premier mode de réalisation et représentée sur la figure 1, est décrite ci-dessous.

La mémoire 100 comporte plusieurs matrices de cellules mémoires 102, par exemple de type SRAM et réalisées dans plusieurs couches, appelées couches mémoires 104, superposées les unes au-dessus des autres. Sur la figure 1, une seule couche mémoire 104 est représentée. De plus, sur la figure 1, seules quatre cellules mémoires 102 sont représentées, réparties sur deux lignes et deux colonnes d'une matrice 103 de cellules mémoires 102.

Dans le premier mode de réalisation décrit ici, toutes les cellules mémoires 102 présentes dans chaque couche mémoire 104 forme une seule matrice 103 de cellules mémoires 102.

Les cellules mémoires 102 correspondent par exemple à des cellules SRAM comprenant 6 transistors CMOS (6T-SRAM). En variante, les cellules mémoires 102 peuvent correspondre à d'autres types de cellules mémoires SRAM, comprenant plus ou moins de 6 transistors. Les cellules mémoires 102 correspondent par exemple aux cellules mémoires décrites dans au moins l'un des documents suivants : « 5T SRAM With Asymmetric Sizing for Improved Read Stability » de S. Nalam et al., IEEE Journal of Solid-State Circuits, Vol. 46, N°. 10, octobre 2011 ; « An 8T-SRAM for Variability Tolerance and Low-Voltage Operation in High-Performance Caches » de L. Chang et al., IEEE Journal of Solid-State Circuits, Vol. 43, N°. 4, avril 2008 ; « A 32 kb 10T Sub-Threshold SRAM Array With Bit-Interleaving and Differential Read Scheme in 90 nm CMOS » de I.J. Chang et al., IEEE Journal of Solid-State Circuits, Vol. 44, N°. 2, février 2009.

En variante, les cellules mémoires 102 peuvent correspondre à des cellules DRAM comprenant au moins une capacité de stockage couplée à au moins un transistor d'accès.

Dans chaque couche mémoire 104, l'accès à chacune des cellules mémoires 102 disposée sur une même ligne de la matrice 103 est commandé par un signal d'accès envoyé sur une ligne de mots 106 (appelée « word line » en anglais) reliée aux grilles des transistors d'accès (non visibles sur la figure 1) de chacune de ces cellules mémoires 102 disposées sur une même ligne de la matrice 103.

Dans chaque couche mémoire 104, chaque ligne de mots 106 est reliée à la sortie d'un dispositif électronique de sélection 108 par l'intermédiaire duquel le signal d'accès aux cellules mémoires 102 d'une ligne de la matrice 103 est envoyé sur la ligne de mots 106. Chaque dispositif électronique de sélection 108 est configuré pour laisser passer ou non le signal d'accès reçu sur une entrée de donnée du dispositif électronique de sélection 108, en fonction de la valeur d'un signal de sélection reçu sur une entrée de commande du dispositif électronique de sélection 108.

Dans chaque couche mémoire 104, les dispositifs électroniques de sélection 108 ont pour rôle soit de laisser passer les signaux d'accès sur les lignes de mots 106 de cette couche mémoire 104 lorsqu'une opération de lecture ou d'écriture est réalisée dans des cellules mémoires 102 présentes sur cette couche mémoire 104, soit de ne pas laisser passer les signaux d'accès sur les lignes de mots 106 de cette couche mémoire 104 lorsque ces signaux d'accès sont destinés à commander l'accès à des cellules mémoires 102 d'une autre couche mémoire 104, en fonction de la valeur du signal de sélection reçu par tous les dispositifs électroniques de sélection 108 de cette couche mémoire 104.

Dans chaque couche mémoire 104, les entrées de commande de tous les dispositifs électroniques de sélection 108 reliés aux lignes de mots 106 de la matrice 103 de cette couche mémoire 104 sont reliées électriquement entre elles par l'intermédiaire d'une ligne conductrice 110. Ainsi, grâce à un seul signal de commande envoyé sur la ligne conductrice 110 de chacune des couches mémoires 104, l'accès aux cellules mémoires 102 de cette couche mémoire 104 est autorisé ou non selon la valeur de ce signal de commande.

Dans le premier mode de réalisation représenté sur la figure 1, chaque dispositif électronique de sélection 108 comporte une porte de transfert (« transmission gate » en anglais). Dans ce cas, chaque dispositif électronique de sélection 108 comporte une deuxième entrée de commande, non visible sur la figure 1, complémentaire de la première entrée de commande correspondant à celle visible sur la figure 1, et sur laquelle un deuxième signal de sélection, de valeur complémentaire à celle du signal de sélection envoyé sur les premières entrées de commande, est envoyé.

En plus des couches mémoires 104 comprenant les matrices 103 de cellules mémoires 102, la mémoire 100 comporte une couche 112, appelée couche d'électronique de commande, dans laquelle sont réalisés les différents circuits électroniques de commande de la mémoire 100.

La mémoire 100 comporte notamment un circuit d'attaque de lignes de mots (« word line driver» en anglais) et un décodeur d'adresses (« row decoder » en anglais) couplé au circuit d'attaque de lignes de mots, qui sont réalisés dans la couche d'électronique de commande 112. Sur la figure 1, ce circuit d'attaque de lignes de mots et ce décodeur d'adresses sont représentés sous la forme d'un seul bloc référencé 114.

La ligne conductrice 110 de chacune des couches mémoires 104 est reliée au bloc 114 qui délivre les signaux de sélection qui sont chacun destiné à commander les dispositifs électroniques de sélection 108 d'une des couches mémoires 104. Cette liaison est assurée, pour chacune des lignes conductrices 110, par un via 116 réalisé à travers l'empilement de couches de la mémoire 100. Sur la figure 1, ce via 116 est représenté en dehors de l'empilement de couches de la mémoire 100 uniquement pour des raisons de visibilité. En outre, bien que la mémoire 100 comporte au moins autant de vias 116 que de couches mémoires 104, un seul via 116 est représenté sur la figure 1.

Chaque dispositif électronique de sélection 108 forme un interrupteur commandé entre une des lignes de mots 106 et le circuit d'attaque de lignes de mots. Les dispositifs électroniques de sélection 108 sont commandés par un signal de sélection de couche mémoire 104. Un même signal de sélection de couche mémoire 104 est ici transmis aux dispositifs électroniques de sélection 108 se trouvant sur une même couche mémoire 104. Chaque signal de sélection de couche mémoire 104 est transmis sur l'une des lignes électriquement conductrices 1110 couplant le décodeur d'adresses aux entrées de commande des dispositifs électroniques de sélection 108 d'une même couche mémoire 104.

Les entrées de donnés des dispositifs électroniques de sélection 108 sont reliés également au bloc 114 afin que le circuit d'attaque de lignes de mots délivre les signaux d'accès chacun destiné à commander l'accès aux cellules mémoires 102 d'une des lignes d'une matrice 103 de cellules mémoires 102 d'une des couches mémoires 104. Ces liaisons sont assurées par des vias 118 réalisés à travers l'empilement de couches de la mémoire 100. Sur la figure 1, le seul via 118 visible est représenté en dehors de l'empilement de couches de la mémoire 100 uniquement pour des raisons de visibilité.

Etant donné que les signaux d'accès sont transmis à l'ensemble des couches mémoires 104 (le choix de la couche mémoire 104 concernée par ces signaux d'accès étant réalisé grâce aux signaux de sélection envoyés sur les entrées de commande des dispositifs électroniques de sélection 108), chaque via 118 est commun à l'ensemble des couches mémoires 104. Ainsi, un premier via 118 est relié aux entrées des dispositifs électroniques de sélection 108 reliés aux première lignes de cellules mémoires 102 des matrices 103 présentes dans toutes les couches mémoires 104, un deuxième via 118 est relié aux entrées des dispositifs électroniques de sélection 108 reliés aux deuxièmes lignes de cellules mémoires 102 des matrices 103 présentes dans toutes les couches mémoires 104, etc. Chaque via 118 est reliée à une ligne de mots globale 119 formée dans la couche d'électronique de commande 112 et reliée au circuit d'attaque de lignes de mots de la mémoire 100 et à laquelle une ligne de mots 106 de chaque couche mémoire 104 est reliée par l'intermédiaire d'un dispositif électronique de sélection 108 et d'un des vias 118.

Des données de lecture ou d'écriture dans les cellules mémoires 102 sont envoyées ou reçues depuis un circuit d'entrées/sorties 120 réalisé dans la couche d'électronique de commande 112, à travers des vias 121 auxquels sont reliés des lignes de bits 122 et des lignes de bits complémentaires 124. Chaque ligne de bits 122 et chaque ligne de bits complémentaire 124 est reliée à la source ou au drain d'un des transistors d'accès des cellules mémoires 102 d'une même colonne d'une des matrices 103 de cellules mémoires 102. Le circuit d'entrées/sorties inclut notamment des amplificateurs de détection utilisés pour la lecture des données.

Etant donné que les données de lecture ou d'écriture sont transmises à l'ensemble des couches mémoires 104 (le choix de la couche mémoire 104 concernée par ces signaux d'accès étant réalisé grâce aux signaux de sélection envoyés sur les entrées de commande des dispositifs électroniques de sélection 108), chaque via 121 est commun à l'ensemble des couches mémoires 104. Ainsi, un premier via 121 est relié aux lignes de bits 122 reliées aux premières colonnes de cellules mémoires 102 des matrices 103 présentes dans toutes les couches mémoires 104, un deuxième via 121 est relié aux lignes de bits complémentaires 124 reliées aux première colonnes de cellules mémoires 102 des matrices 103 présentes dans toutes les couches mémoires 104, un troisième via 121 est relié aux lignes de bits 122 reliées aux deuxièmes colonnes de cellules mémoires 102 des matrices présentes dans toutes les couches mémoires 104, etc. Chaque via 121 est reliée une ligne de bits globale 123 ou une ligne de bits complémentaire globale 125 reliée au circuit d'entrées/sorties 120 de la mémoire 100 et à laquelle une ligne de bits 122 ou une ligne de bits complémentaire 124 de chaque couche mémoire 104 est reliée.

La mémoire 100 comporte également d'autres éléments et circuits électroniques de contrôle/commande réalisés dans la couche d'électronique de commande 112, comme par exemple un circuit d'assistance à la lecture et à l'écriture, un circuit de décodage de lignes de bits, un circuit de codes de correction d'erreurs, un circuit de gestion de redondances, etc. Du fait que ces éléments sont réalisés dans la couche d'électronique de commande 112, cela permet de réduire la surface nécessaire à la réalisation de la mémoire 100 du fait que ces éléments ne se trouvent pas dans les couches mémoires 104.

Dans le premier mode de réalisation de la mémoire 100 représentée sur la figure 1, chaque dispositif électronique de sélection 108 correspond à une porte de transfert. Les dispositifs électroniques de sélection 108 peuvent toutefois être réalisés par des composants autres que des portes de transfert.

La figure 2 représente une première variante de réalisation d'un dispositif électronique de sélection 108. Selon cette première variante, le dispositif électronique de sélection 108 comporte une porte de transfert 126. Une entrée de donnée 128 de la porte de transfert 126 est destinée à être reliée à l'un des vias 118. Une première entrée de commande 130 de la porte de transfert 126 est destinée à être reliée à l'une des lignes conductrices 110 sur laquelle un signal de sélection d'une couche mémoire 104 est envoyé, et une deuxième entrée de commande 132 de la porte de transfert 126 est destinée à recevoir un deuxième signal de sélection de valeur complémentaire à celle du signal de sélection envoyé sur la première entrée de commande 130. La porte de transfert 126 comporte une sortie 134 reliée au drain d'un transistor NMOS 136. Un signal de maintien est destiné à être appliqué sur la grille du transistor NMOS 136 pour mettre à l'état passant le transistor NMOS 136 lorsqu'aucune opération de lecture ou d'écriture n'est mise en œuvre dans les cellules mémoires 102 associées à la ligne de mots 106 à laquelle le dispositif électronique de sélection 108 est relié.

Le signal de maintien appliqué sur la grille du transistor NMOS 136 peut être commun à tous les dispositifs électroniques de sélection 108 présents sur une même couche mémoire 104. Ainsi, dès lors qu'une opération de lecture ou d'écriture est mise en œuvre dans une cellule mémoire 102 d'une couche mémoire 104, les transistors NMOS 136 de tous les dispositifs électroniques de sélection 108 présents sur cette couche mémoire 104 sont à l'état bloqué. Lorsqu'aucune opération de lecture ou d'écriture n'est mise en œuvre dans l'une des cellules mémoires 102 de cette couche mémoire 104, les transistors NMOS 136 de tous les dispositifs électroniques de sélection 108 présents sur cette couche mémoire sont mis à l'état passant. Selon un exemple de réalisation particulier, les signaux de maintien appliqués sur les grilles des transistors NMOS 136 peuvent correspondre aux deuxièmes signaux de sélection envoyés sur les deuxièmes entrées de commande 132 des portes de transfert 126 auxquelles les transistors NMOS 136 sont couplés.

Selon une autre variante, la grille du transistor NMOS 136 peut recevoir, depuis la couche d'électronique de commande 112, un signal de valeur complémentaire de celle du signal circulant sur la ligne de mot 106 associée au dispositif électronique de sélection comportant le transistor NMOS 136. Ainsi, dans une couche mémoire 104, seul le transistor NMOS 136 associé à la ligne de cellules mémoires 102 dans laquelle une opération de lecture ou d'écriture est mise en œuvre est à l'état bloqué, les autres transistors NMOS 136 présents sur la couche mémoire 104 et qui sont associés aux autres lignes de cellules mémoires 102 étant à l'état passant.

La figure 3 représente une deuxième variante de réalisation des dispositifs électroniques de sélection 108 présents dans la mémoire 100. Selon cette deuxième variante, le dispositif électronique de sélection 108 comporte un transistor PMOS 138. Une entrée de donnée 140, reliée à la source du transistor PMOS 138, est destinée à être reliée à l'un des vias 118. Une entrée de commande 142, reliée à la grille du transistor PMOS 138, est destinée à être reliée à l'une des lignes conductrices 110 sur laquelle un signal de sélection d'une couche mémoire 104 est envoyé. Le drain du transistor PMOS 138 est relié au drain du transistor NMOS 136. Comme dans la première variante décrite ci-dessus, un signal de maintien est destiné à être appliqué sur la grille du transistor NMOS 136 pour mettre à l'état passant le transistor NMOS 136 lorsqu'aucune opération de lecture ou d'écriture n'est mise en œuvre dans les cellules mémoires 102 associées à la ligne de mots 106 à laquelle le dispositif électronique de sélection 108 est relié.

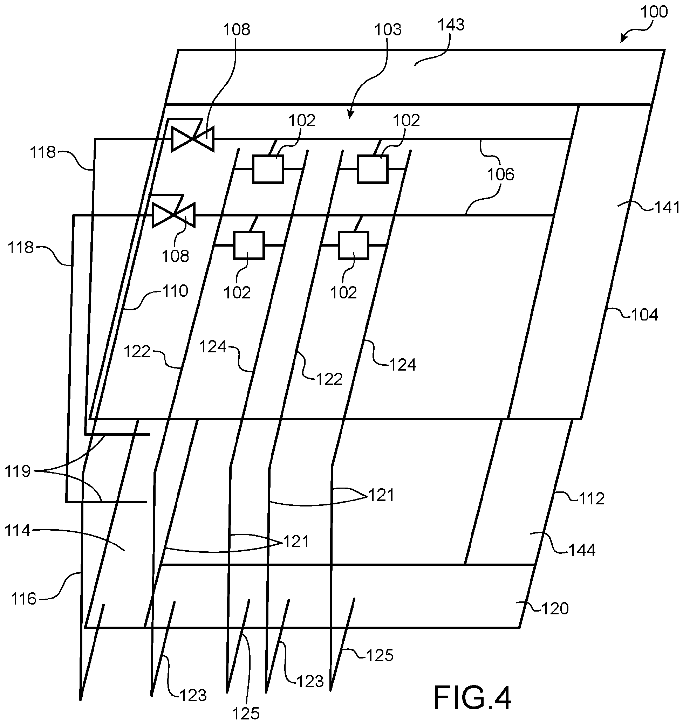

La mémoire 100 selon une variante du premier mode de réalisation est décrite ci-dessous et représentée sur la figure 4.

Dans cette variante, la mémoire 100 comporte tous les éléments de la mémoire 100 précédemment décrite en lien avec la figure 1. En plus de ces éléments, la mémoire 100 comporte également, dans chacune des couches mémoires 104, au moins un circuit de détection de variations PVT (« Process Voltage Temperature ») 141, ainsi qu'un circuit d'application de tension de polarisation de caisson 143 permettant d'appliquer la tension souhaitée sur les caissons des transistors des cellules mémoires 102. Dans chaque couche mémoire 104, cette tension de polarisation caisson peut être par exemple la même pour l'ensemble des cellules mémoires 102 de la couche mémoire 104, ou appliquée indépendamment pour chacune des colonnes de cellules mémoires 102 ou bien encore indépendamment pour des groupes de cellules mémoires 102 adjacentes, par exemple pour chaque ligne de cellules mémoires 102.

La mémoire 100 selon cette variante comporte également, dans la couche d'électronique de commande 112, un circuit de génération de tensions de polarisation de caissons 144 couplé aux circuits de détection de variations PVT 141 présents dans les couches mémoires 104.

Les circuits de détection de variations PVT 141 génèrent un code qui est utilisé pour sélectionner un parmi plusieurs niveaux de tension de polarisation de caisson. Le niveau de tension souhaité et généré par le circuit de génération de tensions de polarisation de caissons 144 peut ensuite être appliqué par les circuits d'application de tension de polarisation de caisson 143 sur les caissons des transistors auxquels ces circuits sont associés.

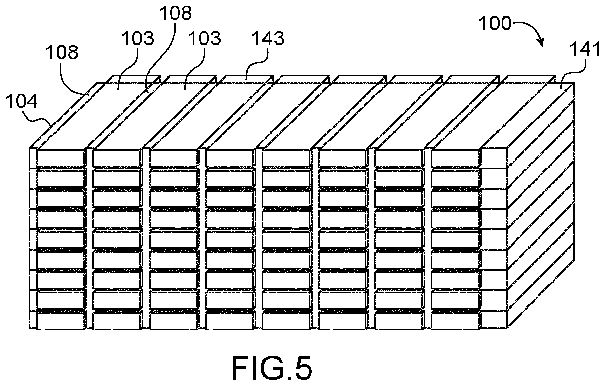

Un deuxième mode de réalisation de la mémoire 100 est décrit ci-dessous en lien avec la figure 5.

Comme dans le premier mode de réalisation, la mémoire 100 est réalisée sous la forme d'un empilement de plusieurs couches mémoires 104 et d'une couche d'électronique de commande 112. Sur la figure 5, seules les couches mémoires 104 sont représentées (neuf couches mémoires 104 sur l'exemple de la figure 5).

Contrairement au premier mode de réalisation dans lequel une seule matrice 103 de cellules mémoires 102 est réalisée dans chacune des couches mémoires 104, chaque couche mémoire 104 de la mémoire 100 selon ce deuxième mode de réalisation comporte plusieurs matrices 103 de cellules mémoires 102 disposées les unes à côté des autres. Sur l'exemple représenté sur la figure 5, chaque couche mémoire 104 comporte huit matrices 103 de cellules mémoires 102. A titre d'exemple, chaque matrice 103 peut comporter 32 colonnes de cellules mémoires 102 tel que chaque ligne de cellules mémoires 102 forme un mot de 32 bits. Le nombre de lignes de cellules mémoires 102 de chaque matrice 103 est choisi en fonction des performances requises pour la mémoire 100 (plus le nombre de lignes de cellules mémoires est important, plus les temps d'accès aux cellules mémoires seront importants.)

Dans la mémoire 100 représentée sur la figure 5, les opérations d'écriture et de lecture dans les cellules mémoires 102 de chaque matrice 103 sont mises en œuvre indépendamment des opérations de lecture ou d'écriture réalisées dans les autres matrices 103 de cellules mémoires 102. Dans chaque couche mémoire 104, chaque matrice 103 de cellules mémoires 102 comporte des lignes de mots qui ne sont pas partagées avec les autres matrices 103 de cellules mémoires 102 de la couche mémoire 104. Pour chaque matrice 103, chaque ligne de mots est reliée à un dispositif électronique de sélection 108 auquel les autres lignes de mots de la matrice et des autres matrices présentes dans la couche mémoire 104 ne sont pas reliées. Sur l'exemple représenté sur la figure 5, chaque matrice 103 de cellules mémoires 102 est juxtaposée aux dispositifs électroniques de sélection 108 auxquels les lignes de mots de la matrice 103 sont reliées.

Cette indépendance des dispositifs électroniques de sélection 108 entre les différentes matrices 103 présentes dans une même couche mémoire 104 permet d'adresser les matrices 103 indépendamment les unes des autres, et notamment des matrices 103 présentes dans différentes couches mémoires 104 et/ou dans une même couche mémoire 104 simultanément.

Comme dans le premier mode de réalisation, chaque couche mémoire 104 comporte un circuit de détection de variation PVT 141, ainsi que des circuits d'application de tensions de polarisation de caissons 143 tels que chaque matrice 103 soit couplée à au moins un de ces circuits 143. Un circuit de génération de tensions de polarisation de caissons 144, non visible sur la figure 5, est réalisé dans la couche d'électronique de commande de la mémoire 100.

Bien que non visibles sur la figure 5, la mémoire 100 comporte également des vias 116 et 118 permettant de relier entre elles les entrées de commande et de données des dispositifs électroniques de sélection 108 formés dans les différentes couches mémoires 104 et qui sont reliés à des matrices 103 de cellules mémoires superposées les unes aux autres.

La mémoire 100 comporte également des vias 121, non visibles sur la figure 5, auxquels les lignes de bits et les lignes de bits complémentaires formées dans les couches mémoires 104 sont reliées et formant des lignes de bits globales et des lignes de bits complémentaires globales reliées à un circuit d'entrées/sorties présent dans la couche d'électronique de commande de la mémoire 100.

Les variantes de réalisation du dispositif électronique de sélection précédemment décrites en lien avec les figures 2 et 3 peuvent s'appliquer à la mémoire 100 selon cette variante du premier mode de réalisation.

Il convient de noter que les types, n ou p, des transistors présents dans les modes de réalisation décrits ci-dessus peuvent être différents de ceux décrits précédemment.

Quel que soit le mode de réalisation de la mémoire 100, d'autres circuits électroniques remplissant par exemple des fonctions de commande, de mémorisation ou de calcul peuvent être intégrés à la mémoire 100, notamment dans la couche d'électronique de commande 112.

Quel que soit le mode de réalisation de la mémoire 100, la mémoire 100 peut comporter une ou plusieurs couches d'électroniques de commande.

Dans les modes de réalisation précédemment décrits, la couche d'électronique de commande est disposée sous les couches mémoires 104. En variante, il est possible que la ou les couches d'électronique de commande soient disposées entre deux couches mémoires 104, ou au-dessus des couches mémoires 104.

Dans les modes de réalisation précédemment décrits, pour n couches mémoires 104, n dispositifs électroniques de sélection 108 sont reliés à un même via 118. En variante, il est possible d'avoir m dispositif électroniques de sélection 118 auxquels ces n dispositifs électroniques 108 sont reliés, avec m et n nombres entiers tels que m < n, afin qu'au moins un de ces vias 118 soit relié à au moins deux dispositifs électroniques de sélection 118.

## Revendications

1. Mémoire 3D-RAM (100) comprenant au moins :
- plusieurs matrices (103) de cellules mémoires (102) réparties dans plusieurs couches mémoires (104) superposées et telles que dans chaque matrice (103) de cellules mémoires (102), les cellules mémoires (102) disposées sur une même ligne de la matrice (103) sont reliées à une ligne de mots (106) associée à ladite ligne de la matrice (103) ;
- un circuit d'attaque de lignes de mots ;
- un décodeur d'adresses couplé au circuit d'attaque des lignes de mots ;
dans laquelle :
- le décodeur d'adresses et le circuit d'attaque de lignes de mots sont disposés dans une couche d'électronique de commande (112) distincte des couches mémoires (104),
- dans chacune des couches mémoires (104), chacune des lignes de mots (106) est reliée à une sortie d'un dispositif électronique de sélection (108) disposé dans la couche mémoire (104) comprenant lesdites lignes de mots (106), dont une entrée de donnée est reliée au circuit d'attaque de lignes de mots, dont une entrée de commande est reliée au décodeur d'adresses, et formant un interrupteur commandé interposé entre ladite ligne de mots (106) et le circuit d'attaque de lignes de mots et configuré pour laisser passer ou non un signal reçu sur son entrée de données en fonction de la valeur d'un signal de sélection d'une des couches mémoires (104) reçu sur son entrée de commande et délivré par le décodeur d'adresses,
- tous les dispositifs électroniques de sélection (108) disposés dans une même couche mémoire (104) sont configurés pour recevoir sur leur entrée de commande un même signal de sélection d'une des couches mémoires (104), et
- chaque dispositif électronique de sélection (108) comporte en outre un élément de polarisation (136) de la ligne de mots (106) reliée au dispositif électronique de sélection (108) configuré pour assurer une polarisation de ladite ligne de mots (106) à un potentiel électrique de référence lorsque le dispositif électronique de sélection (108) ne laisse pas passer le signal reçu sur son entrée de données .

2. Mémoire 3D-RAM (100) selon la revendication 1, dans laquelle les couches mémoires (104) sont superposées les unes au-dessus des autres et sont disposées au-dessus de la couche d'électronique de commande (112), ou dans laquelle la couche d'électronique de commande (112) est disposée entre deux couches mémoires (104).

3. Mémoire 3D-RAM (100) selon l'une des revendications précédentes, dans laquelle chaque dispositif électronique de sélection (108) comporte une porte de transfert (126) formant l'interrupteur commandé, dont une entrée (128) forme l'entrée du dispositif électronique de sélection (108), dont une sortie (134) forme la sortie du dispositif électronique de sélection (108), et dont une entrée de commande forme l'entrée de commande du dispositif électronique de sélection (108).

4. Mémoire 3D-RAM (100) selon l'une des revendications 1 et 2, dans laquelle chaque dispositif électronique de sélection (108) comporte un premier transistor à effet de champ (142) formant l'interrupteur commandé et configuré tel que :
- une première électrode, correspondant à la source ou au drain du premier transistor (142), forme l'entrée de données (140) du dispositif électronique de sélection (108),
- une deuxième électrode, différente de la première électrode et correspondant au drain ou à la source du premier transistor (142), forme la sortie du dispositif électronique de sélection (108),
- une grille forme l'entrée de commande (142) du dispositif électronique de sélection (108).

5. Mémoire 3D-RAM (100) selon l'une des revendications 3 et 4, dans laquelle chaque élément de polarisation (136) comporte un deuxième transistor à effet de champ (136) configuré tel que :
- une première électrode, correspondant à la source ou au drain du deuxième transistor (136), est reliée à la sortie du dispositif électronique de sélection (108),
- une deuxième électrode, différente de la première électrode et correspondant au drain ou à la source du deuxième transistor (136), est reliée au potentiel électrique de référence,
- une grille est reliée à un circuit de contrôle disposé dans la couche d'électronique de commande (112).

6. Mémoire 3D-RAM (100) selon l'une des revendications précédentes, comportant en outre des lignes de mots globales (119), chaque ligne de mots globale (119) étant reliée à au moins une entrée d'un dispositif électronique de sélection (108) présent dans chacune des couches mémoires (104).

7. Mémoire 3D-RAM (100) selon l'une des revendications précédentes, dans laquelle :
- dans chaque matrice (103) de cellules mémoires (102), les cellules mémoires (102) disposées sur une même colonne de la matrice sont reliées à une ligne de bits (122) et une ligne de bits complémentaire (124) associées à ladite colonne de la matrice (103) ;
- les lignes de bits (122) sont reliées à des lignes de bits globales (123) telles que chaque ligne de bits globale (123) soit reliée à au moins une ligne de bits (122) de chacune des couches mémoires (104), et les lignes de bits complémentaires (124) sont reliées à des lignes de bits complémentaires globales (125) telles que chaque ligne de bits complémentaire globale (125) soit reliée à au moins une ligne de bits complémentaire (124) de chacune des couches mémoires (104) ;
- les lignes de bits globales (123) et les lignes de bits complémentaires (125) globales sont reliées à des amplificateurs de détection disposés dans la couche d'électronique de commande (112) et configurés pour réaliser une lecture des cellules mémoires (102).

8. Mémoire 3D-RAM (100) selon l'une des revendications précédentes, dans laquelle chaque couche mémoire (104) comporte plusieurs matrices (103) de cellules mémoires (102).

9. Mémoire 3D-RAM (100) selon la revendication 7 ou selon les revendications 7 et 8, dans laquelle, dans chacune des couches mémoires (104), chacune des lignes de bits (122) et chacune des lignes de bits complémentaires (124) est reliée à une entrée d'un deuxième dispositif électronique de sélection disposé dans la couche mémoire (104) comprenant lesdites lignes de bits (122) et lignes de bits complémentaires (124), dont une entrée de commande est reliée à un circuit de commande de lecture disposé dans la couche d'électronique de commande (112), dont une sortie est reliée à l'un des amplificateurs de détection, et qui est configuré pour laisser passer ou non un signal reçu sur son entrée de données en fonction de la valeur d'un signal reçu sur son entrée de commande.

10. Mémoire 3D-RAM (100) selon l'une des revendications précédentes, comportant entre outre :
- dans chacune des couches mémoires (104), au moins un circuit de détection de variations de procédé, tension et température (141) et un circuit d'application de tension de polarisation de caissons de transistors (145) des cellules mémoires (102),
- dans la couche d'électronique de commande (112), un circuit de génération de tensions de polarisation de caissons (144) couplé aux circuits de détection de variation de procédé, tension et température (141) et aux circuits d'application de tension de polarisation de caissons de transistors (145) des cellules mémoires (102).

11. Mémoire 3D-RAM (100) selon l'une des revendications précédentes, dans laquelle les cellules mémoires (102) sont de type SRAM.
